# EUROPEAN PATENT APPLICATION

(11) **EP 4 456 136 A1**
(43) Date of publication of application: **30.10.2024**
(21) Application number: 22909442.0
(22) Date of filing: 09.10.2022
(51) Int. Cl.: H01L 27/00

(54) **ORGANIC-INORGANIC HYBRID SHORT-WAVE INFRARED PHOTOELECTRIC DETECTOR, ARRAY FORMED BY SAME, AND PREPARATION METHOD RELATED THERETO**

(30) Priority: 21.12.2021 CN 202111570736
(71) Applicant: Guangzhou Guangda Innovation Technology Co., Ltd., Guangzhou, Guangdong 510700 (CN)
(72) Inventor: HUANG, Fei, Guangzhou, Guangdong 510700 (CN); SONG, Yu, Guangzhou, Guangdong 510700 (CN); YU, Gang, Guangzhou, Guangdong 510700 (CN); YANG, Xiye, Guangzhou, Guangdong 510700 (CN)
(74) Representative: Cueto, Sénida
(86) International application number: PCT/CN2022/124106
(87) International publication number: WO 2023/116124

(57) **Abstract**

The present invention relates to an organic-inorganic hybrid short-wave infrared photoelectric detector. A photosensitive layer of the short-wave infrared photoelectric detector comprises a lead sulfide quantum dot thin film with an energy gap ≤ 1.24 eV, and a donor-acceptor-blended organic semiconductor structure. Compared with a photoelectric detector with pure lead sulfide quantum dots, the organic-inorganic hybrid photosensitive layer improves the external quantum efficiency of the photoelectric detector in a short-wave infrared region, reduces a dark current density, and improves a response speed, such that the specific detectivity of the photoelectric detector is improved by an order of magnitude. It is worth mentioning that the photoelectric detector can show excellent comprehensive performance under a zero-bias voltage or a relatively low reverse bias voltage. The present invention further relates to an array formed by the photoelectric detector, and a preparation method related thereto.

## Description

### TECHNICAL FIELD

The present invention relates to the field of photoelectric detectors, and particularly relates to an organic-inorganic hybrid short-wave infrared photoelectric detector, an array formed by the same, and a preparation method related thereto.

### BACKGROUND

Short-wave infrared photoelectric detectors have attracted great attention from academia and industry due to their wide application in night vision, lidar, medical diagnosis, image sensing and other fields. At present, commercial high-performance short-wave infrared photoelectric detectors are based on III-V compound semiconductors. However, these inorganic photoelectric detectors have some deficiencies. On the one hand, they are fabricated by epitaxial crystal growth technology; on the other hand, when preparing image sensors, the traditional III-V compound semiconductor photoelectric detectors need to be integrated into silicon-based readout circuits through flip-chip bonding techniques or wire bonding techniques, resulting in limitations on pixel size, pixel count, moreover, complex manufacturing processes also hinder their applications in markets where cost, resolution, and/or form factor are crucial.

In contrast, lead sulfide quantum dots have advantages such as solution processability, tunable absorption spectra, low cost, and easy integration into readout circuits. However, long-chain ligands of the lead sulfide quantum dots hinder charge transfer, the long-chain ligands need to be replaced with short-chain ligands during preparation. The commonly used ligand exchange methods include solution-phase ligand exchange and solid-state ligand exchange. For short-wave infrared-absorbing lead sulfide quantum dots, on the one hand, it is very difficult for the solution-phase ligand exchange to fabricate quantum dots with particle sizes exceeding 5 nm, and on the other hand, when a thin film for a hole transport layer PbS-EDT commonly used in lead sulfide quantum dot photoelectric detectors is fabricated, layer-by-layer solid-state ligand exchange and prolonged air oxidation are required. Such process leads, easily, to the formation of a large number of surface defects, charge recombination centers are formed accordingly, external quantum efficiency of a device is reduced, and noises in a dark state increase. Therefore, the performance of the lead sulfide quantum dot photoelectric detectors is still weaker than that of commercial InGaAs photoelectric detectors.

In order to solve this problem, Oliver Hayden *et al.* fabricated a photoelectric detector with a three-component bulk heterojunction structure by blending long-chain ligand lead sulfide quantum dots with organic donor-acceptor materials, the detector exhibits lower dark current density and higher specific detectivity in the visible to near-infrared region (DOI: 10.1038/NPHOTON.2009.72). In addition, researchers from Tianjin University proposed a phototransistor structure based on lead sulfide quantum dots/P3HT, the phototransistor structure exhibits higher photoelectric gain and external quantum efficiency, but its response speed is low, restricting its scope of application. Professor Jizheng Wang *et al.* from Chinese Academy of Sciences developed a photoconductive photoelectric detector with lead sulfide quantum dots/organic bilayer heterojunction structure, which performs photoelectric detection based on changes in resistivity after illumination. Due to a photoelectric gain effect, spectral responsivity was improved. However, it requires a reverse bias voltage of 40 V, and its response speed is only 0.4 s. In contrast, photoelectric detectors with diode structures have faster response speeds. However, the external quantum efficiency of diode-based photoelectric detectors in short-wave infrared regions is still below 20% under zero bias, and the dark current density thereof still lags behind that of the commercial InGaAs photoelectric detectors.

Therefore, it is necessary to provide a new device structure to solve the current problem of limited performance of the photoelectric detector with lead sulfide quantum dots.

### SUMMARY

Objectives of the present invention are to provide an organic-inorganic hybrid short-wave infrared photoelectric detector and an array thereof. Compared with the traditional photoelectric detector of lead sulfide quantum dots, the organic-inorganic hybrid short-wave infrared photoelectric detector has higher external quantum efficiency and a lower dark current density in a short-wave infrared region, its detection sensitivity is therefore greatly improved. The present invention further provides the method of making for the organic-inorganic hybrid short-wave infrared photoelectric detector.

In the present invention, the term "photosensitive layer" refers to a layer of thin film responsible for absorbing photons and generating free electrons and holes in a device structure.

In the present invention, the term "energy gap" refers to the optical energy gap of a semiconductor material, and a value thereof is obtained in a way of 1240 dividing by its cut-off wavelength at an absorption edge of the semiconductor material.

In the present invention, the term "cathode interface layer" refers to an N-type material layer that is near the cathode in the device structure and is capable of transporting electrons and blocking holes.

In the present invention, the term "anode interface layer" refers to a P-type material layer that is near the anode in the device structure and is capable of transporting holes and blocking electrons. In the present invention, the term "spectral response region" refers to an effective operating optical band of the photoelectric detector and an array thereof, which is defined as a corresponding wavelength range where the external quantum efficiency is greater than 10%.

In the present invention, the term "patterning processing" refers to a processing flow that enables a thin film layer of a certain material to form a certain shape pattern through means such as a mask or photolithography.

In the present invention, the term "solution-phase ligand exchange" refers to a process flow for obtaining lead sulfide quantum dots of a short chain ligand by performing ligand exchange in a solution during the synthesis process of the lead sulfide quantum dots.

In the present invention, the term "solid ligand exchange" refers to a process flow for preparing a thin film through solution processing of the lead sulfide quantum dots with a long chain ligand, followed by soaking in a short chain ligand solution and performing solvent cleaning, so as to obtain a thin film of lead sulfide quantum dot with a short chain ligand.

One objective of the present invention is to provide an organic-inorganic hybrid short-wave infrared photoelectric detector.

The organic-inorganic hybrid short-wave infrared photoelectric detector, including a photosensitive layer, where the photosensitive layer is a multi-layer structure, the multi-layer structure at least includes a structure formed by superimposing a lead sulfide quantum dot layer with a ligand coordination and an organic semiconductor layer, and the ligand is selected from a substance containing a specific unit 3; where the specific unit 3 is selected from one or more of fluorine ions, chloride ions, bromide ions, iodine ions, sulfur ions, thiocyanate ions, hydroxide ions, ammonium ions, sulfhydryl groups, amino groups, carboxyl groups and hydroxyl groups; the organic semiconductor layer is formed by blending at least one donor and one acceptor; and an energy gap of lead sulfide quantum dots is ≤1.24 eV.

Further, in the photosensitive layer, an absolute value of a difference between an energy level of a conduction band minimum of the lead sulfide quantum dots and an energy level of a lowest unoccupied molecular orbital of the acceptor is ≤0.3 eV; and an absolute value of a difference between an energy level of a valance band maximum of the lead sulfide quantum dots and an energy level of a highest occupied molecular orbital of the donor is ≤0.3 eV.

Further, in the photosensitive layer, donor material is selected from a P-type organic semiconductor based on a specific unit 1, and acceptor material is selected from an N-type organic semiconductor based on a specific unit 2, where the specific unit 1 contains one or more of the following structures: 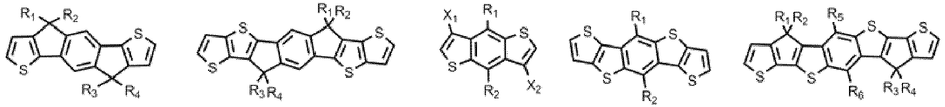 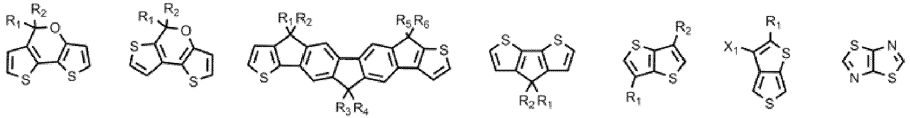 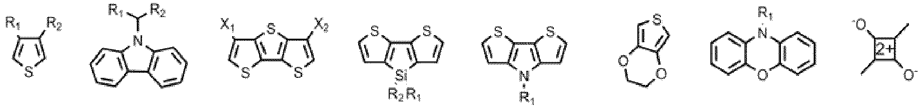 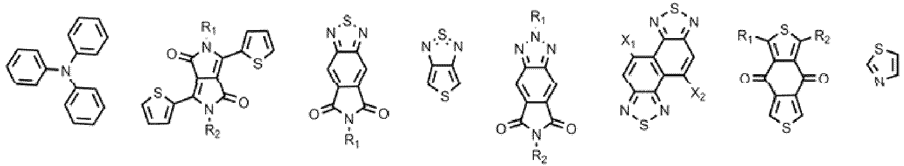 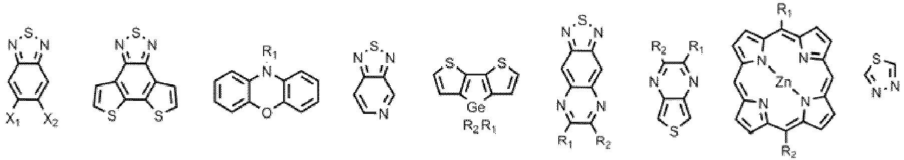 the specific unit 2 contains one or more of the following structures: 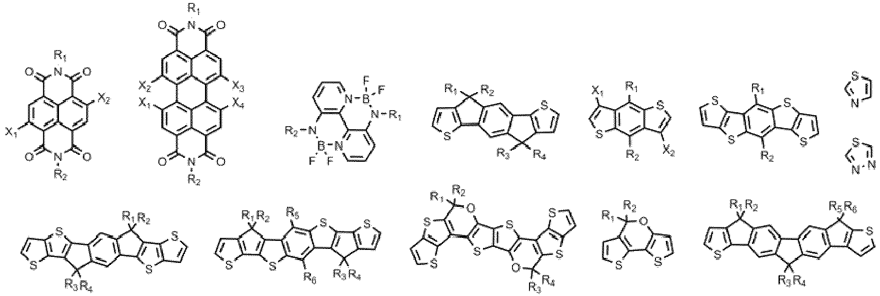 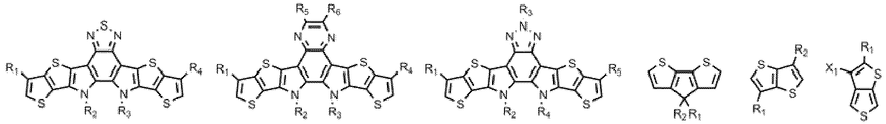 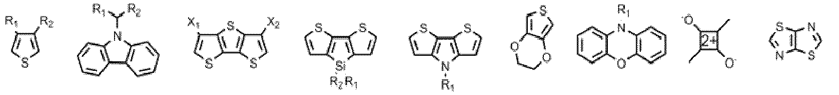 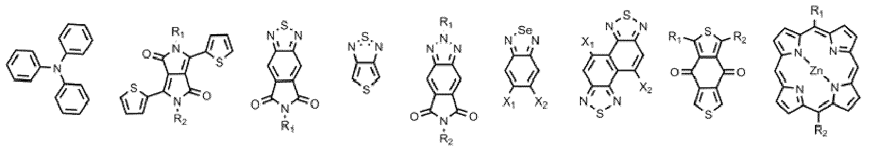 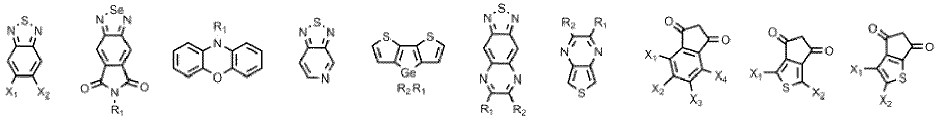 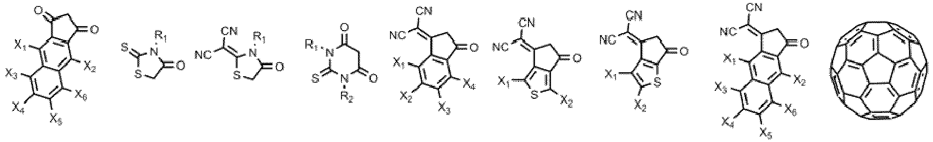 where the R₁-R₆ are independently selected from an alkyl group having a number of carbon atoms of 1-40, or an alkyl derivative having a number of carbon atoms of 1-40; one or more of carbon atoms on the alkyl derivative are substituted by one or more of hydrogen atoms, oxygen atoms, alkenyl groups, alkynyl groups, aryl groups, hydroxyl groups, amino groups, carbonyl groups, carboxyl groups, ester groups, cyano groups, and nitro groups; and/or one or more of hydrogen atoms on the alkyl derivative are substituted by one or more of fluorine atoms, chlorine atoms, bromine atoms, and iodine atoms; and the X₁-X₆ are independently selected from one or more of hydrogen atoms, fluorine atoms, chlorine atoms, cyano groups, and nitro groups.

Preferably, the donor material in the organic semiconductor layer is one of polymer donors JD40 and P3HT, and the acceptor material in the organic semiconductor layer is one of fullerene acceptor PC₇₁BM and non-fullerene acceptors IEICO-4F and Y6. Specific structures of the foregoing units are shown below.

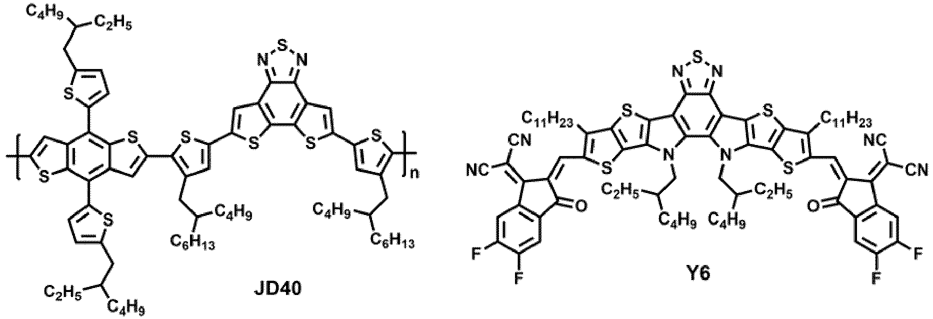

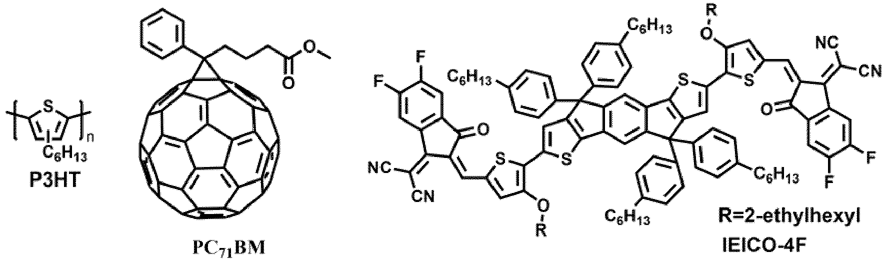

Further, a thickness of the lead sulfide quantum dot layer is 10-500 nm.

Further, the substance containing the specific unit 3 is selected from one or more of 3-mercaptopropionic acid, 1,4-benzenedithiol, chromium chloride, lead iodide, lead bromide, methylammonium lead chloride iodide, sodium sulfide, ammonium thiocyanate, and 1-ethyl-3-methylimidazolium iodide.

Further, a particle size of the lead sulfide quantum dots is 3-20 nm.

Further, a thickness of the organic semiconductor layer is 5-1000 nm.

Further, the organic-inorganic hybrid short-wave infrared photoelectric detector is selected from an "inverted" structure or a "normal" structure; where the "inversed" structure sequentially, from bottom to top, includes a substrate, a bottom electrode as a cathode, a cathode interface layer, a lead sulfide quantum dot layer, an organic semiconductor layer, an anode interface layer, a top electrode as an anode, and a packaging layer; and the "normal" structure sequentially, from bottom to top, includes a substrate, a bottom electrode as an anode, an anode interface layer, a lead sulfide quantum dot layer, an organic semiconductor layer, a cathode interface layer, a top electrode as a cathode, and a packaging layer from bottom to top.

Further, an energy gap of material of the cathode interface layer and an energy gap of material of the anode interface layer are both greater than the energy gap of the lead sulfide quantum dots in the photosensitive layer, an energy gap of the donor and an energy gap of the acceptor. Further, a thickness of the cathode interface layer and the thickness of the anode interface layer are both less than a thickness of the photosensitive layer.

Further, the material of the cathode interface layer is selected from an organic compound 1, an inorganic compound 1, or a combination thereof; where the organic compound 1 is selected from fullerene and derivatives thereof, naphthalene diimide and derivatives thereof, perylene diimide and derivatives thereof, 4,7-diphenyl-1,10-phenanthroline, polyethyleneimine, polyethoxy ethyleneimine, 2,9-dimethyl-4,7-biphenyl-1,10-phenanthroline, [9,9-dioctylfluorene-9,9-bis(N,N-dimethylaminopropyl)fluorene], bromo-[9,9-dioctylfluorene-9,9-bis(N, N-dimethylaminopropyl)fluorene], 8-hydroxyquinoline lithium, 1,3,5-tris(1-phenyl-1H-benzimidazol-2-yl)benzene, bis(2-methyl-8-quinoline)-4-(phenylphenol)aluminum, 1,3,5-tris[(3-pyridyl)-benzene-3-yl]benzene, or a mixture or composite of the above materials; and
the inorganic compound 1 is selected from zinc oxide, tin oxide, magnesium oxide, aluminum-doped zinc oxide, magnesium-doped zinc oxide, gallium-doped zinc oxide, titanium oxide, tantalum oxide, zinc sulfide, chromium sulfide, or a mixture or composite of the above materials. Further, the material of the anode interface layer is selected from an organic compound 2, an inorganic compound 2, or a combination thereof; where the organic compound 2 is selected from one or more of 4,4'-cyclohexylidenebis[N,N'-bis(4-methylphenyl)aniline], N,N'-bis(naphthyl-1-yl)-N,N'-bis(phenyl)-benzidine, N,N'-bis(naphthyl-1-yl)-N,N'-bis(phenyl) -2,7-diamino9,9'-spirobi[fluorene], 2,2',7,7'-tetrakis[N,N-di(4-methoxyphenyl)amino]-9,9'-spirobi[fluorene], 4,4',4"-tris(carbazol-9-yl)triphenylamine, poly (4-butyltriphenylamine), polyvinyl carbazole, polystyrene-N,N'-diphenyl-N,N'-bis-(3-methylphenyl)-(1,1)-biphenyl-4,4'-diamine perfluorocyclobutane, and poly(3,4-ethylenedioxythiophene) mixed polystyrene sulfonate; and the inorganic compound 2 is selected from tungsten oxide, molybdenum oxide, vanadium oxide, chromium oxide, nickel oxide, copper oxide, cuprous oxide, cuprous thiocyanate, copper sulfide, copper iodide, or a mixture or composite of the above materials.

Further, the cathode and/or the anode have a transmittance greater than 20% in a spectral response region.

Another objective of the present invention is to provide an array of the organic-inorganic hybrid short-wave infrared photoelectric detector, and a photosensitive pixel of the array of the photoelectric detector includes the organic-inorganic hybrid short-wave infrared photoelectric detector.

Further, the array of the photoelectric detector includes a substrate, where the substrate includes a pixel readout circuit composed of silicon-based complementary metal-oxide-semiconductor field-effect-transistors (CMOS-FETs) or thin film transistors (TFTs).

Further, the array of the photoelectric detector includes a photosensitive layer and a bottom electrode, where the bottom electrode is a cathode or an anode, and the bottom electrode is adjacent to the substrate; a size of the photosensitive pixel of the array of the organic-inorganic hybrid short-wave infrared photoelectric detector is the same as that of the bottom electrode; the bottom electrode is subjected to patterning processing; and the photosensitive layer is not subjected to patterning processing.

Further, the size of the photosensitive pixel of the array of the organic-inorganic hybrid short-wave infrared photoelectric detector is less than 50 µm.

Another objective of the present invention is to provide preparation methods of the above-mentioned the organic-inorganic hybrid short-wave infrared photoelectric detector, and the array of the organic-inorganic hybrid short-wave infrared photoelectric detector, including the following steps:
(1) cleaning the substrate and preparing the readout circuit;
(2) performing film formation and photolithography patterning of the bottom electrode;
(3) performing film formation of the cathode interface layer or preparing the anode interface layer;
(4) preparing the photosensitive layer;
(5) performing film formation of the anode interface layer or preparing the cathode interface layer;
(6) preparing the top electrode; and
(7) preparing the packaging layer.

The bottom electrode and the top electrode are opposite electrodes, and under the condition that the bottom electrode is an anode, the top electrode is a cathode, and vice versa.

Further, the "preparing the photosensitive layer" includes the following steps:
Preparing the lead sulfide quantum dot thin film: the lead sulfide quantum dot thin film is prepared by adopting a one-step film formation method after solution-phase ligand exchange, or a step-by-step film formation method after solid-state ligand exchange.

Further, the "preparing the photosensitive layer" includes the following steps: preparing the organic semiconductor thin film: the organic semiconductor thin film is prepared by adopting a solution film formation method or a vacuum thermal evaporation deposition method.

Further, the "preparing the cathode interface layer" and the "preparing the anode interface layer" are independently selected from one or more of solution film formation, sol-gel film formation, vacuum thermal evaporation, atomic layer deposition, chemical vapor deposition, electrodeposition, and anodic oxidation.

Further, the "preparing the cathode" and the "preparing the anode" are independently selected from one or more of vacuum thermal evaporation, electron beam evaporation, molecular beam evaporation or plasma sputtering, atomic layer deposition or liquid film formation followed by reduction conversion, electroplating or electrodeposition.

Further, the "preparing the packaging layer" is selected from one of vacuum thermal evaporation, chemical vapor deposition, atomic layer deposition, plasma sputtering, and liquid film formation. The present invention has the following beneficial effects:
(1) The organic-inorganic hybrid short-wave infrared photoelectric detector provided in the present invention includes a photosensitive layer, the photosensitive layer includes a lead sulfide quantum dot thin film, and a donor-acceptor-blended organic semiconductor thin film. Compared with the traditional pure lead sulfide quantum dot photosensitive layer, on one hand, the organic semiconductor thin film does not need complex layer-by-layer solution processing, and the thin film can be directly prepared only through one-step solution processing, which simplifies the preparation process and avoids the introduction of surface defects during the preparation process, and is beneficial to forming good interface morphology and improving charge transport; on the other hand, the introduction of the organic semiconductor thin film blended with the P-type material and the N-type material is beneficial to not only increasing the built-in electric field of the device, increasing the width of the depletion layer, but also adjusting the balance of transport rates between the holes and the electrons in the photosensitive layer. Therefore, the dark current, the external quantum efficiency, the specific detectivity and the response speed of the organic-inorganic hybrid short-wave infrared photoelectric detector are significantly improved, and finally the overall performance thereof is comparable to that of the commercial InGaAs photoelectric detector.
(2) Particularly, when the energy level difference between the donor-acceptor and the lead sulfide quantum dots is smaller, even if the donor and acceptor materials used hardly absorb the short-wave infrared incident light, the photosensitive layer of the lead sulfide quantum dot thin film/organic semiconductor thin film blended with the P-type material and the N-type material can still significantly improve the external quantum efficiency of the photoelectric detector in the short-wave infrared region, which benefits from a smaller difference of energy level between the conduction band minimum of the lead sulfide quantum dots and the lowest unoccupied molecular orbital of the acceptor, and a smaller difference of energy level between the valance band maximum of the lead sulfide quantum dots and the highest occupied molecular orbital of the donor, such that the transport of photo-induced electrons or holes through the photosensitive layer to the corresponding electrode is improved, non-radiative recombination loss is reduced, an open-circuit voltage is improved, and the charge generation and transport efficiency inside the device is further increased.
(3) It is worth mentioning that the organic-inorganic hybrid short-wave infrared photoelectric detector can operate under zero-bias voltage or a relatively low reverse bias voltage (such as - 0.1 V), and can achieve a specific detectivity comparable to that of a gain-type short-wave infrared detector. Compared with an operating voltage 10-50 V of the gain-type short-wave infrared detector, such a lower voltage, on the one hand, is beneficial to reducing the energy consumption of device operation; on the other hand, compared with the slow response speed of the gain-type photoelectric detector, the organic-inorganic hybrid short-wave infrared photoelectric detector has a sub-microsecond response speed, which indicates that the organic-inorganic hybrid short-wave infrared photoelectric detector can be used in the field of high-speed photoelectric detection.
(4) The organic-inorganic hybrid short-wave infrared photoelectric detectors in the present invention can be used to form a photoelectric detector array, and the array formed by the photoelectric detector can be directly integrated onto a TFT/CMOS backplane through solution processing. An image sensor array can be made without patterning a photosensitive layer with photolithography or the like, such that an image sensor array can be directly prepared. A pixel of the array of the photoelectric detector can be simply defined by the size and shape of the bottom electrode (anode/cathode). That is to say, A pixel dimension is consistent with that of the bottom electrode, no need to pattern the other layers between the bottom and the top electrodes. Such image array structure is fundamentally different from the image detectors made with inorganic semiconductor wafers. Traditional CMOS image sensor arrays with front and back illuminations and charge coupled device (CCD) image arrays require lithographic patterning and isolation between pixels within the photosensitive layer to reduce signal crosstalk among the pixels. The lithographic patterning involved deep trench etching and complex post-etching treatment, limiting pixel pitch, process yield, and device cost. When the thin-film photoelectric detector is used as an image sensor pixel, the crosstalk between pixels is greatly weakened due to the reduction of the thickness of the pixel elements. Therefore, this type of photoelectric detector arrays simplifies the array structure and the corresponding manufactural processes, enhances the responsivity, reduces the manufacture cost, reduces the signal crosstalk among adjacent pixels, improves the detection sensitivity to weak light, and improves the signal-to-noise ratio of the image sensor array.

### BRIEF DESCRIPTION OF DRAWINGS

**FIG. 1** is a schematic diagram of a device structure of an organic-inorganic hybrid short-wave infrared photoelectric detector in Embodiment 1 according to the present invention. Reference numerals in the figure: 1-substrate; 2-bottom electrode; 3-cathode interface layer or anode interface layer; 4-photosensitive layer; 5-anode interface layer or cathode interface layer; 6-top electrode; and 7-packaging layer.
**FIG. 2** is a schematic diagram of an energy level of a photosensitive layer of an organic-inorganic hybrid short-wave infrared photoelectric detector in Embodiment 1 according to the present invention.
**FIG. 3** is a cross-sectional view of an array of the organic-inorganic hybrid short-wave infrared photoelectric detector in Embodiments 4-5 according to the present invention. Reference numerals in the figure: 301-pixel readout circuit; 302-bottom electrode (cathode or anode); 303-cathode interface layer or anode interface layer; 304-photosensitive layer; 305-anode interface layer or cathode interface layer; 306-top electrode (correspondingly anode or cathode); and 307-packaging layer.
**FIG. 4** (a) shows a diagram of dark current test of Comparative Examples 1-3 in Test Example 1 and FIG. 4 (b) shows a diagram of dark current test of Embodiments 1-3 in Test Example 1.
**FIG. 5** (a) shows a diagram of external quantum efficiency test of Comparative Examples 1-3 operating under -0.1 V in the Test Example 2; and FIG. 5(b) shows a diagram of external quantum efficiency test of Embodiments 1-3 operating under -0.1 V in the Test Example 2.
**FIG. 6** (a) shows a diagram of specific detectivity test of Comparative Examples 1-3 operating under -0.1 V in Test Example 3; and FIG. 6(b) shows a diagram of specific detectivity test of Embodiments 1-3 operating under -0.1 V in Test Example 3.
**FIG. 7** (a)-(c) show response curves of Comparative Examples 1-2 and Embodiment 2, respectively, operating under -0.1 V with a 1550 nm pulsed light source.

### DETAILED DESCRIPTION

In order to more clearly illustrate the technical solution in the present invention, the following embodiments are enumerated. Unless otherwise specified, raw materials, reactions and posttreatment methods stated in the embodiments are all common commercially available raw materials and technical means known to those skilled in the art.

In the embodiments of the present invention, substrates can be made of various insulating materials or high-resistance semiconductor materials, and can have both flat surfaces and curved surfaces with specific shape. For an organic-inorganic hybrid short-wave infrared photoelectric detector array used for an image sensor, a substrate thereof is integrated with an array of pixel readout circuit. For a photoelectric detector array having a high photosensitive pixel density, a substrate with integrated pixel readout circuits is often made with a monocrystalline silicon substrate through CMOS process. For a photoelectric detector array having a medium-and-low photosensitive pixel density, a substrate can be a readout circuit integrated with a thin film transistor on a glass, ceramic, or plastic substrate. For an image array with ultra-large scale and high photosensitive pixel density, pixel readout circuits on a substrate can also be made hybrid circuits of both CMOS and TFT.

An anode/cathode serving as a bottom electrode, and a cathode/anode serving as the corresponding top electrode, which can be selected from a variety of materials.

For an organic-inorganic hybrid short-wave infrared photoelectric detector with a bottom illumination structure and an array thereof, the cathode/anode serving as the bottom electrode is transparent or partially transparent in the required wavelength range, with an optical transmittance higher than 20%. The cathode/anode serving as the bottom electrode can be a transparent metal oxide (such as indium tin oxide, zinc oxide, and aluminum-doped zinc oxide), or a nitride (such as titanium nitride) and a nitrogen-oxygen compound of a corresponding metal. Further, the anode/cathode serving as the top electrode can be thicker metal material, and can be, but is not limited to, aluminum, silver, titanium, tantalum, molybdenum, copper, chromium, gold, nickel, and the like.

For an organic-inorganic hybrid short-wave infrared photoelectric detector with a top illumination structure and an array thereof, the cathode/anode serving as the bottom electrode can make use of incident light in a wavelength range required for reflection to optimize the photosensitivity in a specific wave band, and desired electrical conductivity and optical reflectivity can be achieved simultaneously by selecting an appropriate metal material. Further the anode/cathode serving as the top electrode is transparent or partially transparent in a desired wavelength range, and the optical transmittance of the electrode is higher than 20%. In addition to thin metal and the transparent metal oxide, the transparent or partially transparent anode/cathode serving as the top electrode can also be implemented with nano-metal particles or a nano-metal wire mesh. For a photoelectric detector with a bi-directional - illumination structure and an array thereof, both the cathode/anode serving as the bottom electrode and an anode/cathode layer serving as the top electrode need to have a high transmittance (higher than 20%) for a detection wavelength. It is worth noting that a thin-film photoelectric detector and an array thereof can be fabricated on a substrate with a variety of materials and with different confocal planes, and can be used for bi-directional optical detection or omni-directional three-dimensional detection.

A packaging layer is arranged on the top electrode to ensure that the photoelectric detector or the array of the photoelectric detector operates stably in various usage environments and during a target service life thereof. Under the condition that the photoelectric detector or the array of the photoelectric detector adopts the bottom incident structure, the packaging layer does not need to be optically transparent. Under the condition that the photoelectric detector or the array of the photoelectric detector adopts the top incident structure, the packaging layer needs to be transparent in an operating band, and the optical transmittance is required to be higher than 50%. The packaging layer can be formed through various vacuum coating methods, such as thermal evaporation, molecular beam coating or plasma sputtering, and atomic layer deposition. It can also be fabricated by a liquid film formation method, such as drip coating, dip coating, spin coating, and various printing method. In addition to using one material, the packaging layer can also be alternated with a multi-layer film. In addition to improving the packaging performance, the alternating film structure can also be used to optimize an optical resonant cavity structure of a thin film photodiode in the operating band, thereby optimizing optical sensitivity and specific detectivity thereof.

Common inorganic packaging materials include silicon oxide, silicon nitride, silicon oxynitride, aluminum oxide, zirconium oxide, magnesium oxide, and magnesium fluoride, and common organic packaging materials include polymethyl methacrylate, polyethylene oxide, polystyrene, polyvinylpyrrolidone, polycarbonate, polyacrylic acid, epoxy resin, parylene, polysiloxane, and polysilazane.

Energy gaps of all donor materials and acceptor materials in the embodiments of the present invention were tested using an ultraviolet-visible absorption spectrum method. The specific test method is as follows: donor (or the acceptor) material is dissolved in a chloroform or chlorobenzene solvent to obtain a dissolved solution, the dissolved solution is processed onto a quartz sheet through the spin coating to obtain a film, the film is used for testing an absorption spectrum, and an optical energy gap is obtained in a way of 1240 dividing by an absorption edge cut-off wavelength of the material.

In the embodiments of the present invention, an energy level of a valance band maximum, or an energy level of a highest occupied molecular orbital (HOMO) of the lead sulfide quantum dots, the donor material and the acceptor material are tested using an atmospheric photoelectron spectrometer. An energy level of a conduction band minimum, or an energy level of a lowest unoccupied molecular orbital (LUMO) of the corresponding material is obtained by adding the corresponding HOMO energy level to the optical energy gap thereof.

In the embodiments of the present invention, the light transmittance of the cathode/anode serving as the bottom electrode and an anode/cathode serving as the top electrode in a photoresponsive area of a device can be tested using a spectrometer. The specific method is as follows: a metal film with a thickness same as that of the electrode of the device is prepared on the quartz sheet through vacuum thermal evaporation, and a transport spectrum of the electrode is measured.

### Embodiment 1

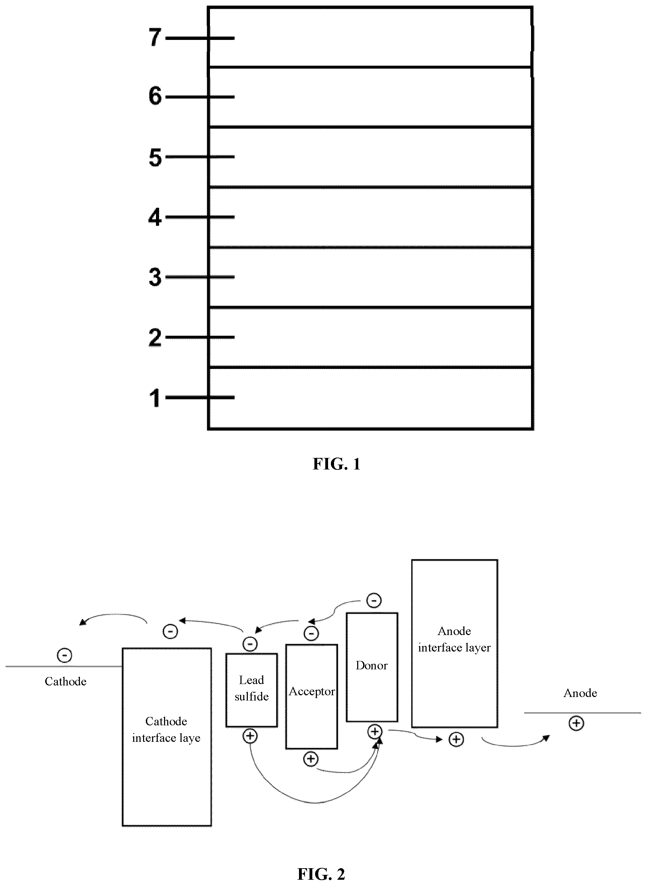

A device structure of an organic-inorganic hybrid short-wave infrared photoelectric detector in this embodiment is shown in FIG. 1, including a glass substrate (2 mm), a cathode (150 nm) serving as a bottom electrode, a cathode interface layer (30 nm), a photosensitive layer (260 nm), an anode interface layer (10 nm), an anode (100 nm) as a top electrode, and a packaging layer. Specifically, the cathode was made from indium tin oxide (ITO); the cathode interface layer was made from zinc oxide; the anode interface layer was made from molybdenum oxide; the photosensitive layer was of a double-layer structure, including a lead sulfide quantum dot layer (200 nm) and an organic semiconductor layer (60 nm) composed of a polymer donor JD40 and a non-fullerene acceptor Y6; the anode was made from metallic silver; and the packaging layer was made from epoxy resin.

An energy gap of the lead sulfide quantum dots was calculated as 0.83 eV, an energy level of a conduction band bottom thereof was -4.37 eV, and an energy level of a valance band maximum thereof was -5.20 eV; an energy gap of the polymer donor JD40 was calculated as 1.96 eV, an energy level of a lowest unoccupied molecular orbital thereof was -3.32 eV, and an energy level of a highest occupied molecular orbital thereof was -5.28 eV; an energy gap of the non-fullerene acceptor Y6 was calculated as 1.33 eV, an energy level of a lowest unoccupied molecular orbital (LUMO) thereof was -4.10 eV, and an energy level of a highest occupied molecular orbital (HOMO) thereof was -5.43 eV; a transmittance of the cathode of the organic-inorganic hybrid short-wave infrared photoelectric detector in the photosensitive layer was measured to be greater than 90%; and a preparation method of the organic-inorganic hybrid short-wave infrared photoelectric detector includes the following steps:
S1. perform ultrasonic treatment and cleaning of an ITO conductive substrate with isopropanol, detergent, deionized water and acetone in sequence, with the duration of each treatment being 20 min; put the cleaned conducting ITO substrate into an oven at 60°C for drying for 5 h; and perform plasma surface treatment of the ITO conductive substrate (a vacuum degree of 2 mPA; and a duration of 20 s);
S2. dissolve 0.4 g of zinc acetate in a mixed solvent of 4 mL of 2-methoxyethanol and 110 µL of ethanolamine, heat and stir at 50°C for 10 h to obtain a sol-gel zinc oxide precursor solution, perform spin coating at 3300 rpm for 30 s, and anneal at 150°C for 30 min to obtain a zinc oxide film with a thickness of 30 nm;
S3. perform spin coating with a solution comprising lead sulfide quantum dots wrapped by an oleic acid ligand onto the zinc oxide film, perform a solid ligand exchange using a methanol solution of tetrabutylammonium iodide as a short-chain ligand, and finally clean twice using a methanol solvent to obtain a passivated lead sulfide quantum dot thin film. The above steps are repeated four times to obtain a lead sulfide quantum dot layer with a specified thickness;
S4. blend the polymer donor JD40 and the non-fullerene acceptor Y6 at a mass ratio of 1:1 to obtain a mixture, add the mixture into a chloroform solvent to obtain a dissolved solution, perform spin coating of the dissolved solution onto the lead sulfide quantum dot layer to prepare the organic semiconductor layer with a specified thickness, and finally place the organic semiconductor layer on a hotplate at 80°C for annealing treatment for 5 min;
S5. transfer the above structure to a thermal evaporation apparatus, and deposit a thin film of the molybdenum oxide with a specified thickness over the thin film of the organic semiconductor layer through thermal evaporation at a rate of 0.1 Å/s under vacuum conditions of 5 × 10⁻⁷ Torr; and
S6. deposit a silver thin film with a specified thickness on the thin film of the molybdenum oxide with a specified thickness as an anode under the vacuum conditions of 5 × 10⁻⁷ Torr to obtain the organic-inorganic hybrid short-wave infrared photoelectric detector.

FIG. 1 is a schematic structural diagram of a device structure of an organic-inorganic hybrid short-wave infrared photoelectric detector in Embodiment 1 according to the present invention. FIG. 2 is a schematic diagram of an energy level of a photosensitive layer of an organic-inorganic hybrid short-wave infrared photoelectric detector in Embodiment 1, and it can be concluded from the figure that:
An energy level difference of the lowest unoccupied molecular orbitals (or the conduction band minimums) between the lead sulfide quantum dots and the acceptor material is less than 0.3 eV, and an energy level difference of the highest occupied molecular orbitals (or the valance band maximums) between the lead sulfide quantum dots and the donor material is also less than 0.3 eV, such a small energy level difference is beneficial to transport of photo-induced electrons or holes through the photosensitive layer to the corresponding electrode, and also beneficial to reducing non-radiative recombination loss, improving an open-circuit voltage and the built-in electric field of the device, and further increasing the charge generation and transport efficiency inside the device.

### Embodiment 2

A device structure and materials used in this embodiment, as well as a device preparation method herein were the same as those in Embodiment 1. The only difference was that the organic semiconductor layer in Embodiment 2 was formed by blending a polymer donor JD40 and a non-fullerene acceptor IEICO-4F.

An energy gap of the non-fullerene acceptor IEICO-4F was calculated as 1.24 eV, an energy level of ta lowest unoccupied molecular orbital thereof was -4.20 eV, and an energy level of a highest occupied molecular orbital thereof was -5.44 eV.

Other parameters of the same materials used in this embodiment were-the same as those in Embodiment 1.

### Embodiment 3

A device structure and materials used in this embodiment, as well as a device preparation method herein were-the same as those in Embodiment 1. The only difference was that the organic semiconductor layer in Embodiment 3 was formed by blending a polymer donor P3HT with a non-fullerene acceptor PC₇₁BM, and the chloroform solvent was replaced with chlorobenzene.

An energy gap of the polymer donor P3HT was calculated as 2.0 eV, an energy level of a lowest unoccupied molecular orbital thereof was -3.00 eV, and an energy level of a highest occupied molecular orbital thereof was -5.00 eV; and an energy gap of the non-fullerene acceptor PC₇₁BM was calculated as 2.13 eV, an energy level of a lowest unoccupied molecular orbital thereof was -4.08 eV, and an energy level of a highest occupied molecular orbital thereof was -6.21 eV; Other parameters of the same materials used in this embodiment were the same as those in Embodiment 1.

### Embodiment 4

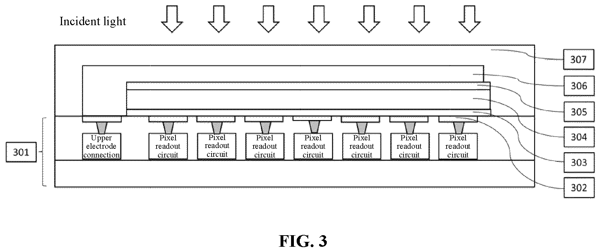

This embodiment provides a photoelectric detector array formed based on the organic-inorganic hybrid short-wave infrared photoelectric detector in Embodiment 2. A device structure of the array of the photoelectric detector is shown in FIG. 3. As can be seen from the figure, the array of the photoelectric detector, from bottom to top, include in order pixel readout circuits 301 fabricated on a monocrystalline silicon substrate and composed of metal-oxide-semiconductor field-effect transistors (MOS-FET), and each pixel readout circuit is linked to one bottom electrode (an cathode here) array 302 that defines a pixel size. A cathode interface layer 303, a photosensitive layer 304, an anode interface layer 305, a top electrode (an anode here) 306 and a packaging layer 307 were arranged above the cathode array. A continuous structure in the entire array region was formed from layer 303 to layer 307, and patterning processing among neighbor pixels was not required.

Specifically, the bottom electrode array were made with aluminum, titanium or titanium-aluminum alloy with thickness of 100 nm, the cathode interface layer was a zinc oxide thin film (30 nm), the photosensitive layer includes a lead sulfide quantum dot layer and an organic semiconductor layer, where the lead sulfide quantum dot layer was a thin film layer (200 nm) after four times of solid state ligand exchange, the material composition of the organic semiconductor layer was the same as the organic semiconductor layer (60 nm) in Embodiment 2, the anode interface layer was a molybdenum oxide thin film (10 nm), the top electrode layer was a stacked structure of a silver electrode (10 nm) and a molybdenum oxide thin film (50 nm), and the packaging layer was made from epoxy resin.

An optic transmittance of the anode of the organic-inorganic hybrid short-wave infrared photoelectric detector was measured to be greater than 50% in 300-1700 nm range.

The array has a pixel pitch size of 25 µm, and the number of pixels of 1 × 256 or 1 × 512. Imaging test was carried out with these arrays. Test results indicated that the organic-inorganic hybrid short-wave infrared photoelectric detector shown in FIG. 3, for which the pixel is defined by the bottom electrode, can be used for digital camera applications with high pixel density.

A preparation method of the organic-inorganic hybrid short-wave infrared photoelectric detector includes the following steps:
S1. transfer the silicon wafer comprising the MOS-FET pixel readout circuits into an evaporation glove box, and deposit an aluminum metal electrode array of a specified thickness through thermal evaporation under vacuum conditions of 5×10⁻⁷torr;
S2-S5. preparation methods of a zinc oxide film, a lead sulfide quantum dot thin film, a P-type material and N-type material blended organic semiconductor blended thin film, and a molybdenum oxide thin film were the same as those in Embodiment 2; and
S6. deposit a silver thin film with a specified thickness onto the thin film of the molybdenum oxide under the vacuum conditions of 5 × 10⁻⁷ Torr, evaporate the silver electrode and wait for 5-10 min, and then evaporate a layer of molybdenum oxide thin film with a specified thickness as an optical adjustment layer, where an oxide-silver-oxide anode stack can increase the optic transmittance in the infrared region.

### Embodiment 5

A device structure and materials used in this embodiment, as well as a device preparation method herein are the same as those in Embodiment 4. The only difference is that the pixel readout circuits 301 in Embodiment 4 are replaced with pixel readout circuits composed of thin film transistors (TFT) on a glass substrate.

### Comparative Example 1

A device structure and materials used in this comparative example, as well as a device preparation method herein were the same as those in Embodiment 1. The only difference was that the organic semiconductor layer in Embodiment 1 was replaced with a lead sulfide quantum dot layer subjected to ligand exchange with 1,2-ethanedithiol. Correspondingly, S4 in the preparation method in Embodiment 1 was replaced with the following processing conditions:
S4. perform spin coating of a solution of lead sulfide quantum dot wrapped by an oleic acid ligand onto the lead sulfide quantum dot layer, perform a solid ligand exchange using an acetonitrile solution of 1,2-ethanedithiol (EDT) as a short-chain ligand, clean twice using an acetonitrile solvent to obtain a passivated PbS-EDT thin film, and finally place the PbS-EDT thin film on a hotplate at 80°C for annealing treatment for 5 min.

### Comparative Example 2

A device structure and materials used in this comparative example, as well as a device preparation method herein were the same as those in Embodiment 1. The only difference was that the material of the organic semiconductor layer in Embodiment 1 was replaced with a single-component polymer donor JD40.

### Comparative Example 3

A device structure and materials used in this comparative example, as well as a device preparation method herein were the same as those in Embodiment 1. The only difference was that the photosensitive layer in Comparative Example 3 includes a lead sulfide quantum dot thin film with an energy gap of 1.77 eV and an organic semiconductor thin film formed by blending a polymer donor JD40 and a non-fullerene acceptor IEICO-4F.

In this comparative example, an energy gap of the lead sulfide quantum dots was calculated as 1.77 eV, an energy level of a conduction band bottom thereof was -3.87 eV, and an energy level of a valance band maximum thereof was -5.64 eV.

In order to test technical effects of the photosensitive layer structures in the above embodiments and comparative examples, the following tests were carried out.

### Test Examples

### Test Example 1

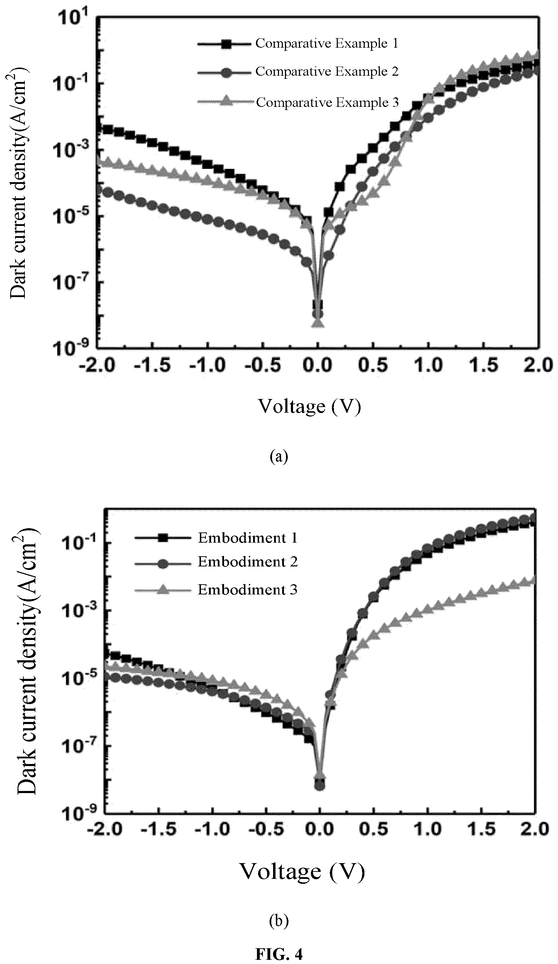

Dark current test: the test was performed using the method in the literature (DOI: 10.1063/5.0018274). Test results are shown in FIG. 4. It can be clearly seen from FIGs. 4(a) and 4(b) that, compared with Comparative Examples 1-3, Embodiments 1-3 all show reduced dark current densities. Further, compared with Comparative Example 1, Embodiments 1-3 show a reduction of about 2-3 orders of magnitude. On the one hand, it indicates that, compared with a photoelectric detector with pure lead sulfide quantum dots, the photosensitive layer of the lead sulfide quantum dot thin film/organic semiconductor thin film blended with the P-type material and the N-type material can effectively reduce the dark current of the photoelectric detector. On the other hand, compared with a photosensitive layer of the lead sulfide quantum dot/P-type organic semiconductor thin film, the photosensitive layer of the lead sulfide quantum dot thin film/organic semiconductor thin film blended with the P-type material and the N-type material can significantly reduce the dark current of the photoelectric detector. The introduction of the acceptor component in the organic semiconductor layer is beneficial to increasing the built-in electric field of the device and increasing a width of the depletion layer acceptor and thus the device dark current is reduced. Further, comparing Comparative Example 3 with Example 2, it can be found that when the energy level differences between the lead sulfide quantum dot and the donor acceptor materials used are small, the corresponding photoelectric detector has a lower dark current density in a dark state.

### Test Example 2

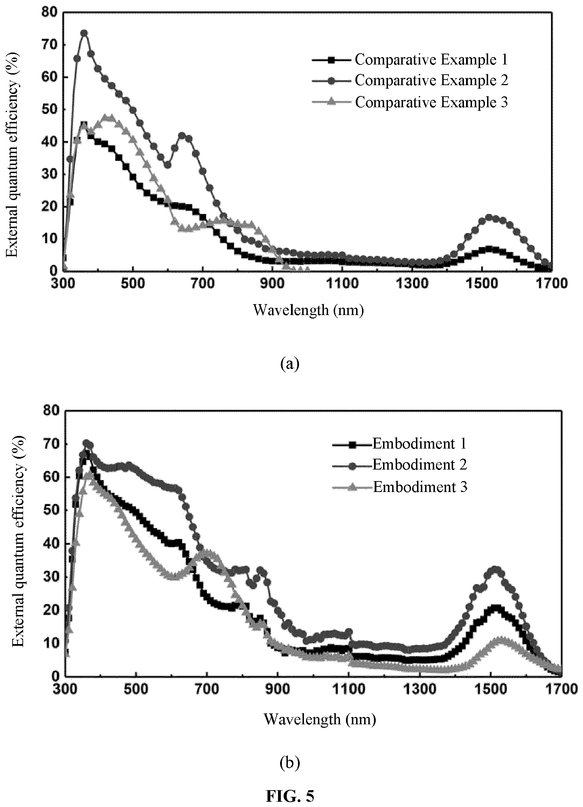

External quantum efficiency test: the test was performed using the method in the literature (DOI:10.1063/5.0018274). Test results are shown in FIG. 5. With reference to FIGs. 5(a) and 5(b), it can be clearly seen that, compared with Comparative Example 1-3, Embodiments 1-2 both show higher external quantum efficiency, and the external quantum efficiency of Embodiments 1-2 at 1520 nm exceeds 20%; although Embodiment 3 exhibits higher external quantum efficiency than Comparative Example 1, the external quantum efficiency of Embodiment 3 is lower than those of Comparative Example 2 and Embodiments 1-2, which indicates that, on the one hand, compared with two photosensitive layers of pure lead sulfide quantum dots and lead sulfide quantum dots/P-type organic semiconductor, the photosensitive layer of the lead sulfide quantum dot thin film/organic semiconductor blend thin film comprising the P-type material and the N-type material can significantly enhance the external quantum efficiency of the photoelectric detector. However, on the other hand, organic semiconductor thin film blended with the P-type material and the N-type material needs to meet certain energy level difference conditions to significantly enhance the photoelectric response capability of the lead sulfide quantum dots at 1520 nm. Compared with Embodiment 3, the differences between the donor-acceptor energy levels and the energy levels of the lead sulfide quantum dots thereof in Embodiments 1-2 are smaller, which are beneficial to transport of photo-induced electrons or holes through the photosensitive layer to the corresponding electrodes, and also beneficial to reducing non-radiative recombination loss, improving the open-circuit voltage, and further increasing the charge generation and transport efficiencies inside the device. Therefore, in spite of no light absorption at 1520 nm, the donor and acceptor can still significantly enhance external quantum efficiency of the photoelectric detector in the entire short-wave infrared region.

Further, it can also be found that, compared with Comparative Example 3, Embodiment 2 has higher external quantum efficiency in an infrared band of 700-1700 nm. This is because, on the one hand, the differences between the energy levels in the lead sulfide quantum dots used in Embodiment 2 and the corresponding donor-acceptor energy levels acceptor thereof is smaller acceptor, which is beneficial to reducing non-radiative recombination loss and promoting the generation of excitons and transfer of charges; and on the other hand, the energy gap of the lead sulfide quantum dots used in Embodiment 2 is 0.83 eV, and the corresponding photosensitive layer itself has strong absorption in the infrared band.

### Test Example 3

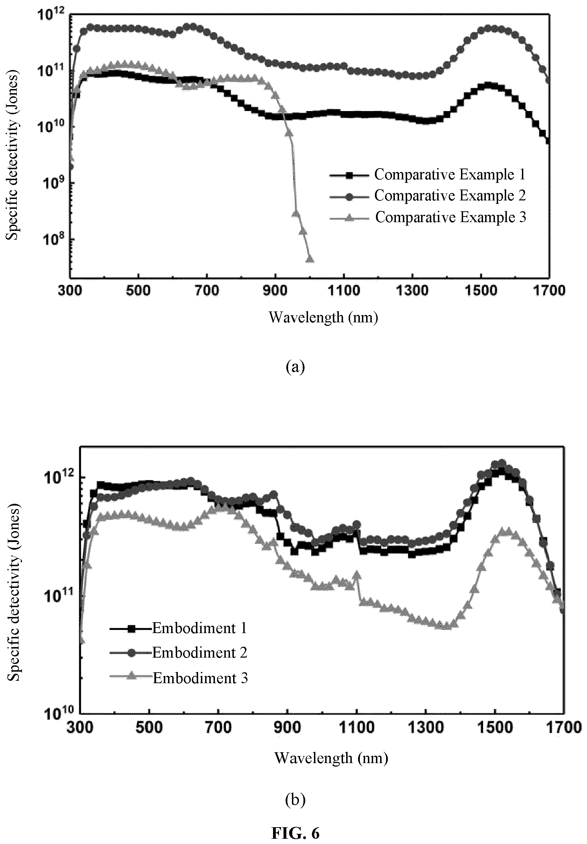

Specific detectivity test: the test was performed using the method in the literature (DOI: 10.1063/5.0018274). Test results are shown in FIG. 6. With reference to FIGs. 6(a) and 6(b), it can be clearly seen that, compared with Comparative Example 1-2, Embodiments 1-2 both show higher specific detectivity, and peak specific detectivities of Embodiments 1-2 both exceed 10¹²Jones at 1520 nm, which are at a comparable level to those of the commercial InGaAs photoelectric detectors; and although Embodiment 3 exhibits higher specific detectivity than Comparative Example 1, the specific detectivity of Embodiment 3 is lower than those of Comparative Example 2 and Embodiments 1-2, which indicates that on the one hand, compared with two photosensitive layers of a pure lead sulfide quantum dots and a lead sulfide quantum dot/P-type organic semiconductor, the photosensitive layer of the lead sulfide quantum dot thin film/organic semiconductor blend thin film comprising the P-type material and the N-type material can improve the specific detectivity of the photoelectric detector; and on the other hand, only when the energy level differences between the donor and acceptor used, and the lead sulfide quantum dots are small, the photosensitive layer of the lead sulfide quantum dot thin film/organic semiconductor blend thin film comprising the P-type material and the N-type material will have a more obvious effect on the improvement of the specific detectivity.

In addition, it is further found that, compared with Comparative Example 3, Embodiment 2 has a higher specific detectivity in the infrared band of 700-1700 nm, which is attributable to a lower dark current density and higher external quantum efficiency in Embodiment 2. It also reveals that when the energy levels of the lead sulfide quantum dots, the donor and the acceptor used meet certain conditions, the corresponding photoelectric detector will exhibit a better specific detectivity in the short-wave infrared band.

### Test Example 4

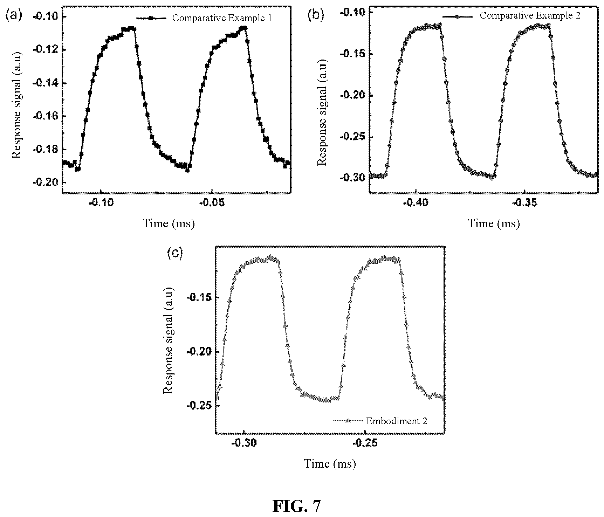

Response time test: the test was performed using the method in the literature (DOI:10.1063/5.0018274), a light source used was a LED of 1550 nm, and an output optical signal thereof was square wave light pulse with a frequency of 20 kHz. Test results are shown in FIG. 7. It can be seen from a response waveform of FIG. 7(a) that the photoelectric detector of the pure lead sulfide quantum dots in Comparative Example 1 is incapable of following the response of the light source, an output electrical signal loses the shape of a square wave, and a response peak appears. It can be seen from FIGs. 7(b) and 7(c) that Comparative Example 2 and Embodiment 2 both represent regular square wave signals, and the response speed of Embodiment 2 is better than that of the Comparative Example 2. The detector rise times (the time required for the response signal to rise from 10% of an amplitude to 90% of the amplitude) of Embodiment 2 and Comparative Example 2 are 7 µs and 9 µs, respectively, which indicate that on the one hand, compared with the photosensitive layer of the pure lead sulfide quantum dots, the photosensitive layer of the lead sulfide quantum dots/organic semiconductor thin film can significantly improve the response speed of the photoelectric detector, this is because the introduction of the organic semiconductor thin film reduces surface defects of the lead sulfide quantum dot thin film, and thus reduces the probability that the photo-induced charges to be captured by the defects; and on the other hand, compared with the photosensitive layer of the lead sulfide quantum dots/P-type organic semiconductor, the photosensitive layer of the lead sulfide quantum dot thin film/organic semiconductor blend thin film comprising the P-type material and the N-type material can significantly improve the response speed of the photoelectric detector, this is because the photosensitive layer of the donor-acceptor-blended organic semiconductor thin film can enlarge the built-in electric field of the device, balance transport rates of holes and electrons inside the device, and reduce the occurrence of charge recombination. In summary, key parameters of the short-wave infrared photoelectric detectors of Comparative Examples 1-3 and Embodiments 1-3 are shown in Table 1 below:

**Table 1 Key parameters of the short-wave infrared photoelectric detectors of Embodiments 1-3 and Comparative Examples 1-3**

| Performance parameters | Dark current density at -0.1 V (A/cm²) | Dark current density at -2 V (A/cm²) | External quantum efficiency (%) | Specific detectivity (Jones) |
|---|---|---|---|---|
| **Embodiment 1** | 1.60×10⁻⁷ | 5.38×10⁻⁵ | 20.73% | 1.12×10¹² |
| **Embodiment 2** | 2.83×10⁻⁷ | 1.12×10⁻⁵ | 32.11% | 1.31×10¹² |
| **Embodiment 3** | 4.04×10⁻⁷ | 2.20×10⁻⁵ | 10.72% | 3.41×10¹¹ |
| **Comparative Example 1** | 7.26×10⁻⁶ | 4.62×10⁻³ | 6.86% | 5.55×10¹⁰ |
| **Comparative Example 2** | 4.08×10⁻⁷ | 6.40×10⁻⁵ | 16.65% | 5.65×10¹¹ |
| **Comparative Example 3** | 5.56×10⁻⁶ | 4.64×10⁻⁴ | 14.59% | 7.06×10¹⁰ |

| | | | | |
|---|---|---|---|---|
| Note: the external quantum efficiency and the specific detectivity of Comparative Examples 1-2 and Embodiments 1-3 were taken from the values corresponding to the wavelength of 1520 nm, and the external quantum efficiency and the specific detectivity of Comparative Example 3 were taken from the values corresponding to the wavelength of 800 nm. | | | | |

The test results above demonstrate that: (1) compared with two photosensitive layers of the pure lead sulfide quantum dots and the lead sulfide quantum dot/P-type organic semiconductor thin film, the photosensitive layer structure of the lead sulfide quantum dot thin film/organic semiconductor blend thin film comprising the P-type material and the N-type material can significantly reduce the dark current of the photoelectric detector, and improve the signal-to-noise ratio and the specific detectivity of the photoelectric detector, The reduction of dark current is attributable to the introduction of the acceptor, which is beneficial to increasing the built-in electric field of the device and increasing the width of the depletion layer; (2) Particularly, when the energy level differences between the donor and acceptor and the lead sulfide quantum dots are smaller, even if the donor and acceptor materials used has little absorption to the infrared incident light in a short-wave region, the photosensitive layer of the lead sulfide quantum dot thin film/organic semiconductor blend thin film comprising the P-type material and the N-type material can still significantly improve the external quantum efficiency of the photoelectric detector in the short-wave infrared region, this is because the smaller energy level difference can improve the transport of the photo-induced electrons and holes through the photosensitive layer to the corresponding electrode, reduce non-radiative recombination loss, improve the open-circuit voltage, and further increase the charge generation and transport efficiency inside the device; (3) it is worth mentioning that when the energy gap of the lead sulfide quantum dots is ≤ 1.24 eV, and the difference between the donor-acceptor energy levels and the energy level of the lead sulfide quantum dots of the acceptor is ≤0.3 eV, the corresponding photosensitive layer can most significantly reduce the dark current density of the photoelectric detector, and improve the external quantum efficiency and specific detectivity of the photoelectric detector in the short-wave infrared region; and (4) the organic-inorganic hybrid short-wave infrared photoelectric detector can operate under a zero-bias voltage or a relatively low reverse bias voltage (such as -0.1 V), and can achieve a specific detectivity comparable to that of a gain-type short-wave infrared detector, which is beneficial to reducing the energy consumption of device operation; further, compared with the millisecond-level response time of the gain-type photoelectric detector, the organic-inorganic hybrid short-wave infrared photoelectric detector has a sub-microsecond-level response speed.

For those skilled in the art, it is apparent that the present invention is not limited to the disclosure of the exemplary embodiments, and the present invention can be implemented in other specific forms without departing from the spirit or basic features of the present invention. Therefore, the embodiments should be regarded as illustrative and non-restrictive no matter from which point of view. The scope of the present invention is defined by the appended claims rather than the above specification, and therefore, it is intended that all changes which fall within the meaning and scope of equivalency of the claims are embraced in the present invention.

In addition, it should be understood that although the description is described according to implementations, each implementation does not include only one independent technical solution, the description is for clarity only, and those skilled in the art should take the description as a whole, the technical solutions in the various embodiments may be appropriately combined to form other implementations understandable by those skilled in the art.

## Claims

1. An organic-inorganic hybrid short-wave infrared photoelectric detector, comprising a photosensitive layer, wherein
the photosensitive layer has a multi-layer structure,
the multi-layer structure at least comprises a structure formed by superimposing a lead sulfide quantum dot layer with a ligand coordination and an organic semiconductor layer, and the ligand is selected from a substance containing a specific unit 3; wherein
the specific unit 3 is selected from one or more of fluorine ions, chloride ions, bromide ions, iodine ions, sulfur ions, thiocyanate ions, hydroxide ions, ammonium ions, sulfhydryl groups, amino groups, carboxyl groups and hydroxyl groups;
the organic semiconductor layer is formed by blending at least one donor and one acceptor; and
an energy gap of lead sulfide quantum dots is ≤ 1.24 eV.

2. The organic-inorganic hybrid short-wave infrared photoelectric detector according to claim 1, wherein, in the photosensitive layer, an absolute value of a difference between an energy level of a conduction band minimum of the lead sulfide quantum dots and an energy level of a lowest unoccupied molecular orbital of the acceptor is ≤ 0.3 eV; and an absolute value of a difference between an energy level of a valance band maximum of the lead sulfide quantum dots and an energy level of a highest occupied molecular orbital of the donor is ≤ 0.3 eV.

3. The organic-inorganic hybrid short-wave infrared photoelectric detector according to claim 1, wherein, in the photosensitive layer, donor material is selected from a P-type organic semiconductor based on a specific unit 1, and acceptor material is selected from an N-type organic semiconductor based on a specific unit 2, wherein the specific unit 1 contains one or more of the following structures: 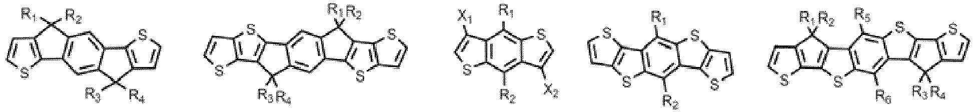 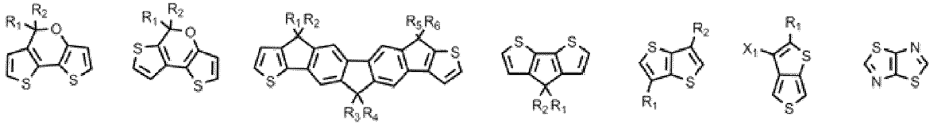 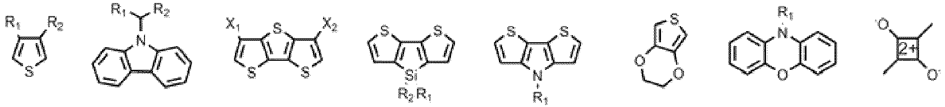 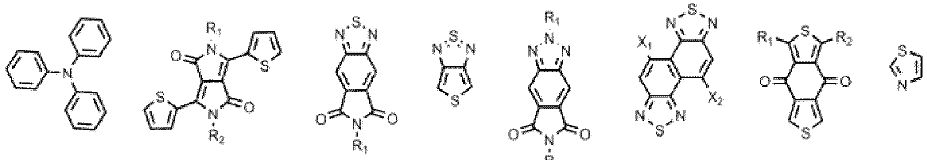 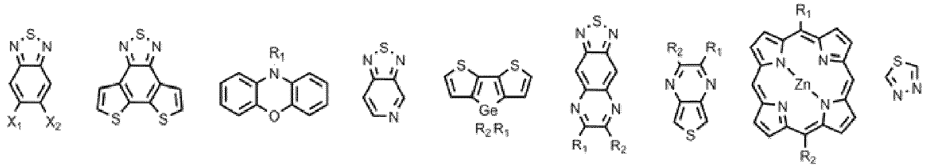 the specific unit 2 contains one or more of the following structures: 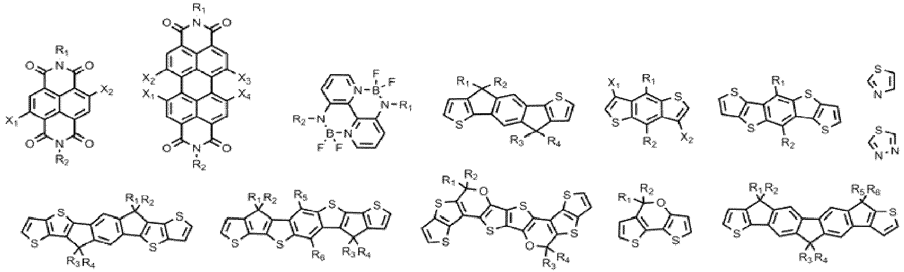 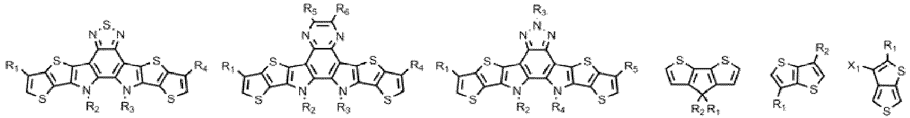 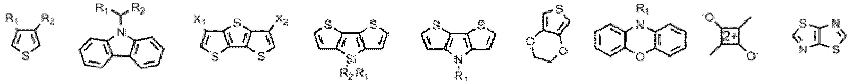 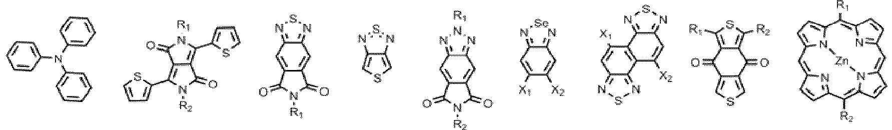 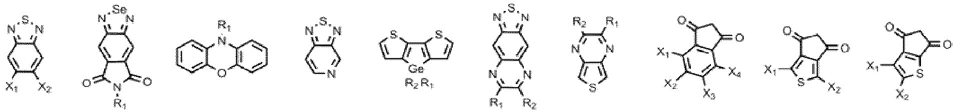 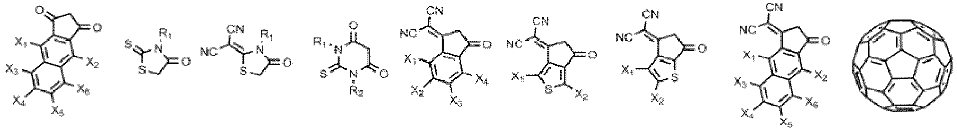
wherein the R₁-R₆ are independently selected from an alkyl group having a number of carbon atoms of 1-40, or an alkyl derivative having a number of carbon atoms of 1-40;
one or more of carbon atoms on the alkyl derivative are substituted by one or more of hydrogen atoms, oxygen atoms, alkenyl groups, alkynyl groups, aryl groups, hydroxyl groups, amino groups, carbonyl groups, carboxyl groups, ester groups, cyano groups, and nitro groups; and/or
one or more of hydrogen atoms on the alkyl derivative are substituted by one or more of fluorine atoms, chlorine atoms, bromine atoms, and iodine atoms; and
the X₁-X₆ are independently selected from one or more of hydrogen atoms, fluorine atoms, chlorine atoms, cyano groups, and nitro groups.

4. The organic-inorganic hybrid short-wave infrared photoelectric detector according to claim 1, wherein a thickness of the lead sulfide quantum dot layer is 10-500 nm.

5. The organic-inorganic hybrid short-wave infrared photoelectric detector according to claim 1, wherein the substance containing the specific unit 3 is selected from one or more of 3-mercaptopropionic acid, 1,4-benzenedithiol, chromium chloride, lead iodide, lead bromide, methylammonium lead chloride iodide, sodium sulfide, ammonium thiocyanate, and 1-ethyl-3-methylimidazolium iodide.

6. The organic-inorganic hybrid short-wave infrared photoelectric detector according to claim 1, wherein a particle size of the lead sulfide quantum dots is 3-20 nm.

7. The organic-inorganic hybrid short-wave infrared photoelectric detector according to claim 1, wherein a thickness of the organic semiconductor layer is 5-1000 nm.

8. The organic-inorganic hybrid short-wave infrared photoelectric detector according to claim 1, wherein the organic-inorganic hybrid short-wave infrared photoelectric detector is selected from an inverted structure or a normal structure, wherein
the inverted structure sequentially comprises a substrate, a bottom electrode as a cathode, a cathode interface layer, a lead sulfide quantum dot layer, an organic semiconductor layer, an anode interface layer, a top electrode as an anode, and a packaging layer from bottom to top; and
the normal structure sequentially comprises a substrate, a bottom electrode as an anode, an anode interface layer, a lead sulfide quantum dot layer, an organic semiconductor layer, a cathode interface layer, a top electrode as a cathode, and a packaging layer from bottom to top.

9. The organic-inorganic hybrid short-wave infrared photoelectric detector according to claim 8, wherein an energy gap of material of the cathode interface layer and an energy gap of material of the anode interface layer are both greater than the energy gap of the lead sulfide quantum dots in the photosensitive layer, the energy gap of the donor and an energy gap of the acceptor.

10. The organic-inorganic hybrid short-wave infrared photoelectric detector according to claim 9, wherein a thickness of the cathode interface layer and a thickness of the anode interface layer are both less than a thickness of the photosensitive layer.

11. The organic-inorganic hybrid short-wave infrared photoelectric detector according to claim 8, wherein the material of the cathode interface layer is selected from an organic compound 1, an inorganic compound 1, or a combination thereof, wherein
the organic compound 1 is selected from fullerene and derivatives thereof, naphthalene diimide and derivatives thereof, perylene diimide and derivatives thereof, 4,7-diphenyl-1,10-phenanthroline, polyethyleneimine, polyethoxy ethyleneimine, 2,9-dimethyl-4,7-biphenyl-1,10-phenanthroline, [9,9-dioctylfluorene-9,9-bis(N,N-dimethylaminopropyl)fluorene], bromo-[9,9-dioctylfluorene-9,9-bis(N,N-dimethylaminopropyl)fluorene], 8-hydroxyquinoline lithium, 1,3,5-tris(1-phenyl-1H-benzimidazol-2-yl)benzene, bis(2-methyl-8-quinoline)-4-(phenylphenol)aluminum, 1,3,5-tris[(3-pyridyl)-benzene-3-yl]benzene, or a mixture or composite of the above materials; and
the inorganic compound 1 is selected from zinc oxide, tin oxide, magnesium oxide, aluminum-doped zinc oxide, magnesium-doped zinc oxide, gallium-doped zinc oxide, titanium oxide, tantalum oxide, zinc sulfide, chromium sulfide, or a mixture or composite of the above materials.

12. The organic-inorganic hybrid short-wave infrared photoelectric detector according to claim 8, wherein the material of the anode interface layer is selected from an organic compound 2, an inorganic compound 2, or a combination thereof; wherein
the organic compound 2 is selected from one or more of 4,4'-cyclohexylidenebis[N,N'-bis(4-methylphenyl)aniline], N,N'-bis(naphthyl-1-yl)-N,N'-bis(phenyl)-benzidine, N,N'-bis(naphthyl-1-yl)-N,N'-bis(phenyl) -2,7-diamino9,9'-spirobi[fluorene], 2,2',7,7'-tetrakis[N,N-di(4-methoxyphenyl)amino]-9,9'-spirobi[fluorene], 4,4',4"-tris(carbazol-9-yl)triphenylamine, poly (4-butyltriphenylamine), polyvinyl carbazole, polystyrene-N,N'-diphenyl-N,N'-bis-(3-methylphenyl)-(1,1)-biphenyl-4,4'-diamine perfluorocyclobutane, and poly(3,4-ethylenedioxythiophene) mixed polystyrene sulfonate; and
the inorganic compound 2 is selected from tungsten oxide, molybdenum oxide, vanadium oxide, chromium oxide, nickel oxide, copper oxide, cuprous oxide, cuprous thiocyanate, copper sulfide, copper iodide, or a mixture or composite of the above materials.

13. An array of the organic-inorganic hybrid short-wave infrared photoelectric detector, wherein a photosensitive pixel of the array comprises the organic-inorganic hybrid short-wave infrared photoelectric detector according to claim 1.

14. The array of the organic-inorganic hybrid short-wave infrared photoelectric detector according to claim 13, wherein the array of the photoelectric detector comprises a substrate, the substrate comprises a pixel readout circuit composed of metal-oxide-semiconductor field-effect transistors or thin film transistors.

15. The array of the organic-inorganic hybrid short-wave infrared photoelectric detector according to claim 13, wherein the array of the photoelectric detector comprises a photosensitive layer and a bottom electrode, wherein the bottom electrode is a cathode or an anode, and the bottom electrode is adjacent to the substrate; wherein
a size of the photosensitive pixel of the array of the organic-inorganic hybrid short-wave infrared photoelectric detector is the same as that of the bottom electrode;
the bottom electrode is subjected to patterning processing; and
the photosensitive layer is not subjected to patterning processing.
